# EUROPEAN PATENT APPLICATION

(11) **EP 4 753 416 A1**
(43) Date of publication of application: **03.06.2026**
(21) Application number: 24847657.4
(22) Date of filing: 18.04.2024
(51) Int. Cl.: H10K 30/81, H10K 30/57, H10K 30/40, H10K 71/00

(54) **SOLAR CELL AND MANUFACTURING METHOD THEREFOR, PHOTOVOLTAIC MODULE, AND PHOTOVOLTAIC DEVICE**

(30) Priority: 31.07.2023 CN 202310943297
(71) Applicant: Contemporary Amperex Technology Co., Limited, Ningde, Fujian 352100 (CN)
(72) Inventor: ZHANG, Zhiying, Ningde, Fujian 352100 (CN); ZHOU, Hongmei, Ningde, Fujian 352100 (CN); WANG, Shidan, Ningde, Fujian 352100 (CN); OUYANG, Chuying, Ningde, Fujian 352100 (CN)
(74) Representative: Gong, Jinping
(86) International application number: PCT/CN2024/088532
(87) International publication number: WO 2025/025691

(57) **Abstract**

A solar cell and a manufacturing method therefor, a photovoltaic module, and a photovoltaic device. The solar cell comprises a first light absorption layer, a composite layer, and a second light absorption layer which are sequentially arranged in a first direction, wherein the first direction is an incident direction of sunlight, and the composite layer comprises a first metal layer and a first metal diffusion inhibition layer arranged on at least one side of the first metal layer. According to the technical solution, the performance of the solar cell is improved.

## Description

### CROSS-REFERENCE TO RELATED APPLICATIONS

The present application claims priority to Chinese Patent Application No. 202310943297.4, entitled "SOLAR CELL, PREPARATION METHOD THEREFOR, PHOTOVOLTAIC MODULE, AND PHOTOVOLTAIC APPARATUS" and filed on July 31, 2023, which is incorporated herein by reference in its entirety.

### TECHNICAL FIELD

The present application relates to the field of solar cell technologies, and in particular, to a solar cell, a preparation method therefor, a photovoltaic module, and a photovoltaic apparatus.

### BACKGROUND

Over recent years, problems such as global energy shortage and environmental pollution have become increasingly prominent, and a solar cell, as ideal renewable energy, has received more attention. The solar cell, also referred to as a photovoltaic cell, is an apparatus that directly converts light energy into electrical energy through a photoelectric effect or a photochemical effect. Within a few years after the solar cell emerges, the solar cell rapidly obtains relatively high photoelectric conversion efficiency and has a good application prospect.

With the development of solar cell technologies, people have increasingly high requirements for performance of the solar cell, such as efficiency and stability of the solar cell. Therefore, how to improve the performance of the solar cell is a technical problem that urgently needs to be resolved.

### SUMMARY

The present application is proposed in view of the foregoing subject, and has an objective of providing a solar cell and a preparation method therefor, a photovoltaic module, and a photovoltaic apparatus, to improve performance of the solar cell.

According to a first aspect, a solar cell is provided, including: a first light absorption layer, a composite layer, and a second light absorption layer that are sequentially arranged along a first direction, where the first direction is an incident direction of sunlight; and the composite layer includes a first metal layer and a first metal diffusion inhibiting layer located on at least one side of the first metal layer.

Embodiments of the present application provide a solar cell. The solar cell includes: a first light absorption layer, a composite layer, and a second light absorption layer that are sequentially arranged along a first direction. The composite layer includes a first metal layer and a first metal diffusion inhibiting layer located on at least one side of the first metal layer. In the technical solutions of the present application, the first metal diffusion inhibiting layer is disposed on at least one side of the first metal layer. In this way, on the at least one side of the first metal layer, the first metal diffusion inhibiting layer separates the first metal layer from another film layer, and the first metal diffusion inhibiting layer prevents metal on the first metal layer from diffusing to the another film layer, to reduce a risk that a function of the another film layer is degraded or damaged due to doping of a metal material. Permeability of the composite layer formed by the first metal layer and the first metal diffusion inhibiting layer on the at least one side of the first metal layer is improved, and a structural design of the composite layer is conducive to improving parallel resistance of the solar cell and is conducive to improving a filling factor of the solar cell. Therefore, the technical solutions provided in the present application are conducive to improving efficiency of the solar cell.

In a possible implementation, the solar cell further includes a first electrode layer, a first carrier transport layer, a second carrier transport layer, a third carrier transport layer, a fourth carrier transport layer, and a second electrode layer, where the first electrode layer, the first carrier transport layer, the first light absorption layer, the second carrier transport layer, the composite layer, the third carrier transport layer, the second light absorption layer, the fourth carrier transport layer, and the second electrode layer are sequentially arranged along the first direction.

In the technical solutions of the present application, a first metal diffusion inhibiting layer is disposed on at least one side of the first metal layer. In this way, on the at least one side of the first metal layer, the first metal diffusion inhibiting layer separates the first metal layer from a carrier transport layer. The first metal diffusion inhibiting layer prevents metal on the first metal layer from diffusing to the carrier transport layer, to reduce a risk of damage to the carrier transport layer.

In a possible implementation, the first carrier transport layer is a hole transport layer, the second carrier transport layer is an electron transport layer, the third carrier transport layer is a hole transport layer, the fourth carrier transport layer is an electron transport layer, and the first metal diffusion inhibiting layer is disposed between the third carrier transport layer and the metal layer. In other words, the first metal diffusion inhibiting layer is disposed on a side of the first metal layer close to the hole transport layer, to separate the first metal layer from the hole transport layer, and reduce a risk of damage to the hole transport layer.

In a possible implementation, a thickness d1 of the first metal diffusion inhibiting layer satisfies: 0.1 nm≤d1≤100 nm.

In a possible implementation, the thickness d1 of the first metal diffusion inhibiting layer satisfies: 5 nm≤d1≤10 nm.

In a possible implementation, a thickness d2 of the first metal layer satisfies: 0.1 nm≤d2≤10 nm.

In a possible implementation, the thickness d2 of the first metal layer satisfies: 0.8 nm≤d2≤1.2 nm.

In a possible implementation, a thickness d of the composite layer satisfies: 1 nm≤d≤210 nm.

In a possible implementation, the thickness d of the composite layer satisfies: 10.8 nm≤d≤21.2 nm.

In the foregoing technical solutions, the thickness of the first metal diffusion inhibiting layer, the thickness of the first metal layer, and the thickness of the composite layer are set within the foregoing range, which is conducive to improving efficiency of the solar cell.

In a possible implementation, a material of the first metal layer includes at least one of gold, silver, copper, aluminum, nickel, chromium, bismuth, platinum, magnesium, molybdenum, tungsten, and alloys thereof.

In a possible implementation, the material of the first metal layer includes at least one of gold, silver, and alloys thereof.

In a possible implementation, a material of the first metal diffusion inhibiting layer includes at least one of a transparent conductive oxide and an elemental carbon material.

In a possible implementation, the transparent conductive oxide includes at least one of indium tin oxide, fluorine-doped tin oxide, indium-doped tungsten oxide, indium-doped zinc oxide, and aluminum-doped zinc oxide; and the elemental carbon material includes at least one of graphite, graphene, and a carbon nanotube.

The foregoing substance is used as the material of the first metal diffusion inhibiting layer, to cover at least one side of the first metal layer, which can reduce a risk that the material of the first metal layer diffuses to the carrier transport layer.

In a possible implementation, a material of the first electrode layer includes: a conductive oxide, where the conductive oxide includes at least one of indium tin oxide, lanthanide-doped indium oxide, boron-doped zinc oxide, fluorine-doped tin oxide, indium-doped tungsten oxide, indium-doped zinc oxide, aluminum-doped zinc oxide, and gallium zinc oxide.

In the foregoing technical solutions, the material of the first electrode layer includes the foregoing conductive oxide, which is conducive to absorbing sunlight by the solar cell.

In a possible implementation, the second electrode layer includes a second metal layer and a second metal diffusion inhibiting layer, and the second metal diffusion inhibiting layer is disposed between the second metal layer and the fourth carrier transport layer.

In the foregoing technical solutions, the second metal diffusion inhibiting layer of the second electrode layer is disposed between the second metal layer of the second electrode layer and the fourth carrier transport layer, which can block a metal material in the second metal layer from diffusing to the fourth carrier transport layer, thereby reducing a risk of damage to the fourth carrier transport layer.

In a possible implementation, a material of the second metal layer includes at least one of gold, silver, copper, aluminum, nickel, chromium, bismuth, platinum, magnesium, molybdenum, tungsten, and alloys thereof; and the second metal diffusion inhibiting layer includes at least one of a transparent conductive oxide and an elemental carbon material.

In a possible implementation, the transparent conductive oxide includes at least one of indium tin oxide, fluorine-doped tin oxide, indium-doped tungsten oxide, indium-doped zinc oxide, and aluminum-doped zinc oxide; and the elemental carbon material includes at least one of graphite, graphene, and a carbon nanotube.

The foregoing substance is used as the material of the second metal diffusion inhibiting layer, and is disposed between the second metal layer and the fourth carrier transport layer, which can reduce a risk that the material of the second metal layer diffuses to the fourth carrier transport layer.

In a possible implementation, a material of the hole transport layer includes a P-type semiconductor, and a material of the electron transport layer includes an N-type semiconductor.

In a possible implementation, the material of the hole transport layer includes at least one of the following materials and derivatives thereof: [4-(3,6-dimethoxy-9H-carbazole-9-yl)butyl]phosphoric acid, [2-(3,6-dimethoxy-9H-carbazole-9-yl)ethyl]phosphoric acid, [4-(3,6-dibromo-9H-carbazole-9-yl)butyl]phosphoric acid, poly[bis(4-phenyl)(2,4,6-trimethylphenyl)amine], poly-3-hexylthiophene, triptycene-cored triphenylamine, 3,4-ethylenedioxythiophene-methoxytriphenylamine, N-(4-aniline)carbazole-spirobisfluorene, poly(3,4-ethylenedioxythiophene)-polystyrene sulfonic acid, polythiophene, nickel oxide, molybdenum oxide, cuprous iodide, and cuprous oxide; and the material of the electron transport layer includes at least one of the following materials and derivatives thereof: bathocuproine, [6,6]-phenyl-C61-methyl isobutyrate, [6,6]-phenyl-C71-methyl butyrate, C60, C70, SnOₓ, and zinc oxide, where a value of x ranges from 1.5 to 2.

The foregoing material used as the hole transport layer and the material used as the electron transport layer can improve efficiency of the solar cell.

In a possible implementation, a material of the first light absorption layer is perovskite, and a material of the second light absorption layer is perovskite.

The perovskite material has advantages such as high conversion efficiency, low costs, and environmental protection, and can be made into a very thin film and applied to the solar cell, which can effectively improve efficiency of the solar cell.

In a possible implementation, a band gap of the material of the first light absorption layer is greater than a band gap of the material of the second light absorption layer.

Sunlight first illuminates the first light absorption layer, and a band gap of the material of the first light absorption layer is greater than a band gap of the material of the second light absorption layer. This is conducive to improving efficiency of the solar cell.

In a possible implementation, a chemical formula of the perovskite in the first light absorption layer and the second light absorption layer is ABX₃, where A includes at least one of CH3(NH₂)₂⁺, CH(NH₂)₂⁺, CH₃NH₂⁺, Li⁺, Na⁺, K⁺, Rb⁺, and Cs⁺; B includes at least one of Pb⁺, Be²⁺, Mg²⁺, Ca²⁺, Sr²⁺, Ba²⁺, Zn²⁺, Ge²⁺, Fe²⁺, Co²⁺, and Ni²⁺; and X includes at least one of Cl⁻, Br , I , SCN , CNO , OCN , OSCN , SH , OH , CP , CN , SeCN , N₃⁻, and NO₂⁻. In this way, specific types of the perovskite are flexibly selected according to an actual requirement.

In a possible implementation, the solar cell further includes a first hole barrier layer, and the first hole barrier layer is located between the first light absorption layer and the second carrier transport layer.

In a possible implementation, the solar cell further includes a second hole barrier layer, and the second hole barrier layer is located between the second light absorption layer and the fourth carrier transport layer.

In the foregoing technical solutions, disposing a hole barrier layer between a light absorption layer and an electron transport layer is conducive to improving electron transport between the electron transport layer and the light absorption layer, thereby improving efficiency of the solar cell.

In a possible implementation, a material of the first hole barrier layer includes at least one of fullerene and derivatives thereof and SnOₓ, where a value of x ranges from 1.5 to 2.

In a possible implementation, a material of the second hole barrier layer includes at least one of fullerene and derivatives thereof and SnOₓ, where a value of x ranges from 1.5 to 2.

The foregoing material used as the material of the hole barrier layer can effectively improve electron transport between the electron transport layer and the light absorption layer, thereby increasing efficiency of the solar cell.

According to a second aspect, a preparation method for a solar cell is provided, including a first light absorption layer, a composite layer, and a second light absorption layer that are sequentially arranged along a first direction, where the first direction is an incident direction of sunlight; and the composite layer includes a first metal layer and a first metal diffusion inhibiting layer located on at least one side of the first metal layer. The solar cell prepared in this method has relatively high cell efficiency.

In a possible implementation, the preparation method further includes: providing a first electrode layer, a first carrier transport layer, the first light absorption layer, a second carrier transport layer, the composite layer, a third carrier transport layer, the second light absorption layer, a fourth carrier transport layer, and a second electrode layer that are sequentially arranged along the first direction.

In a possible implementation, the providing a first electrode layer, the first carrier transport layer, a first light absorption layer, a second carrier transport layer, the composite layer, a third carrier transport layer, the second light absorption layer, a fourth carrier transport layer, and a second electrode layer that are sequentially arranged along the first direction includes: providing the first electrode layer; preparing the first carrier transport layer on the first electrode layer, where the first carrier transport layer is a hole transport layer; preparing the first light absorption layer on the first carrier transport layer; preparing the second carrier transport layer on the first light absorption layer, where the second carrier transport layer is an electron transport layer; preparing the first metal layer on the electron transport layer, and preparing the first metal diffusion inhibiting layer on the metal layer, to obtain the composite layer; preparing the third carrier transport layer on the composite layer, where the third carrier transport layer is a hole transport layer; preparing the second light absorption layer on the third carrier transport layer; preparing the fourth carrier transport layer on the second light absorption layer, where the fourth carrier transport layer is an electron transport layer; and preparing the second electrode layer on the fourth carrier transport layer.

In a possible implementation, the second electrode layer includes a second metal layer and a second metal diffusion inhibiting layer, and the preparing the second electrode layer on the fourth carrier transport layer includes: preparing the second metal diffusion inhibiting layer on the fourth carrier transport layer, and preparing the second metal layer on the second metal diffusion inhibiting layer, to obtain the second electrode layer.

According to a third aspect, a photovoltaic module is provided, including a solar cell according to the first aspect and any possible implementation thereof, and/or a solar cell prepared according to the preparation method according to the second aspect and any possible implementation thereof.

According to a fourth aspect, a photovoltaic apparatus is provided, including a photovoltaic module in the third aspect.

### BRIEF DESCRIPTION OF THE DRAWINGS

To describe the technical solutions in embodiments of the present application more clearly, the following briefly describes the accompanying drawings required in the embodiments of the present application. Apparently, the accompanying drawings in the following descriptions show merely some embodiments of the present application, and a person of ordinary skill in the art may derive other drawings from these accompanying drawings without creative efforts.
FIG. 1 is a schematic diagram of a solar cell according to an embodiment of the present application;
FIG. 2 is a schematic diagram of a solar cell according to an embodiment of the present application;
FIG. 3 is a schematic diagram of a solar cell according to an embodiment of the present application;
FIG. 4 is a schematic diagram of a solar cell according to an embodiment of the present application; and
FIG. 5 is a schematic diagram of a preparation method for a solar cell according to an embodiment of the present application.

### DETAILED DESCRIPTION

Implementations that specifically disclose a solar cell, a preparation method therefor, a photovoltaic module, and a photovoltaic apparatus of the present application will be described in detail with reference to the accompanying drawings as appropriate. However, there are cases in which unnecessary detailed descriptions are omitted. For example, there are cases in which detailed descriptions of well-known items and repeated descriptions of actually identical structures are omitted. This is to avoid unnecessary redundancy in the subsequent descriptions and to facilitate understanding by a person skilled in the art. In addition, the accompanying drawings and the subsequent descriptions are provided for a person skilled in the art to fully understand the present application, and are not intended to limit the subject matter recited in the claims.

A "range" disclosed in the present application is defined in a form of a lower limit and an upper limit. A given range is defined by selecting a lower limit and an upper limit, and the selected lower limit and upper limit define boundaries of a particular range. A range defined in this manner may be inclusive or exclusive of end values, and may be arbitrarily combined, that is, any lower limit may be combined with any upper limit to form a range. For example, if a range from 60 to 120 and a range from 80 to 110 are listed for a particular parameter, it is understood that a range from 60 to 110 and a range from 80 to 120 are also contemplated. In addition, if minimum range values 1 and 2 are listed, and if maximum range values 3, 4, and 5 are listed, the following ranges are all contemplated: 1 to 3, 1 to 4, 1 to 5, 2 to 3, 2 to 4, and 2 to 5. In the present application, unless otherwise specified, a numerical range "a to b" represents an abbreviated representation of any combination of real numbers between a to b, where both a and b are real numbers. For example, a numerical range "0 to 5" represents that all real numbers between "0 to 5" have been listed in this specification, and "0 to 5" is just an abbreviated representation of a combination of these numerical values. In addition, when it is stated that a specific parameter is an integer that is greater than or equal to 2, it is equivalent to disclosing that the parameter is, for example, an integer such as 2, 3, 4, 5, 6, 7, 8, 9, 10, 11, and 12.

Unless otherwise specified, all implementations and optional implementations of the present application may be combined with each other to form new technical solutions.

Unless otherwise specified, all technical features and optional technical features of the present application may be combined with each other to form new technical solutions.

Unless otherwise specified, all steps of the present application may be performed sequentially or randomly, and preferably sequentially. For example, the method includes step (a) and step (b), representing that the method may include step (a) and step (b) performed sequentially, or may include step (b) and step (a) performed sequentially. For example, the reference to the method may further include step (c), representing that step (c) may be added to the method in any order, for example, the method may include step (a), step (b), and step (c), or may include step (a), step (c), and step (b), or may include step (c), step (a), and step (b).

Unless otherwise specified, the terms "include/including" and "comprise/comprising" mentioned in the present application are open-ended. For example, the "including" and "comprising" may represent that other components not listed may be further included or comprised.

Unless otherwise specified, a term "and/or" is inclusive in the present application. For example, a phrase "A and/or B" means "A, B, or both A and B". More specifically, the condition "A or B" is satisfied under any one of the following conditions: A is true (or present) and B is false (or absent); A is false (or absent) and B is true (or present); or both A and B are true (or present).

The solar cell has a good application prospect due to relatively high photoelectric conversion efficiency. In the solar cell, disposition of each film layer is crucial to performance of the solar cell, such as stability and efficiency. For example, to improve the efficiency of the solar cell, a composite layer is disposed between two light absorption layers in a laminated cell. In the related art, a layer of ITO with a thickness ranging from 50 nm to 100 nm is generally prepared as the composite layer, or a layer of elemental metal with a thickness of about 1 nm is prepared as the composite layer. Using only the ITO as the composite layer leads to relatively large lateral conductivity, and as a result, parallel resistance of the cell is reduced. In addition, thicker ITO has higher parasitic absorption, and as a result, a short-circuit current is reduced. Although using the elemental metal as the composite layer can avoid relatively low lateral conductivity, the elemental metal diffuses to a carrier transport layer, and the carrier transport layer is damaged. The foregoing solutions in the related art are not conducive to improving the efficiency of the solar cell.

In view of this, embodiments of the present application provide a solar cell. The solar cell includes: a first light absorption layer, a composite layer, and a second light absorption layer that are sequentially arranged along a first direction, where the first direction is an incident direction of sunlight. The composite layer includes a first metal layer and a first metal diffusion inhibiting layer located on at least one side of the first metal layer. In the technical solutions of the present application, the first metal diffusion inhibiting layer is disposed on at least one side of the first metal layer. In this way, on the at least one side of the first metal layer, the first metal diffusion inhibiting layer separates the first metal layer from another film layer, and the first metal diffusion inhibiting layer prevents metal on the first metal layer from diffusing to the another film layer, to reduce a risk that a function of the another film layer is degraded or damaged due to doping of a metal material. Permeability of the composite layer formed by the first metal layer and the first metal diffusion inhibiting layer on the at least one side of the first metal layer is improved, and a structural design of the composite layer is conducive to improving parallel resistance of the solar cell and is conducive to improving a filling factor of the solar cell. Therefore, the technical solutions provided in the present application are conducive to improving efficiency of the solar cell.

### [Solar cell]

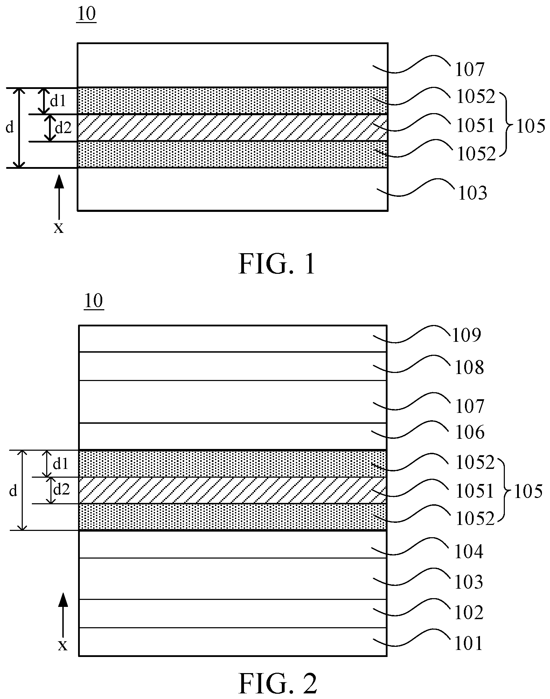

FIG. 1 is a schematic diagram of a solar cell according to an embodiment of the present application. As shown in FIG. 1, the solar cell 10 includes a first light absorption layer 103, a composite layer 105, and a second light absorption layer 107 that are sequentially arranged along a first direction.

The first direction is an incident direction of sunlight. For example, as shown in FIG. 1, the first direction is an x direction (a direction indicated by the arrow).

The composite layer 105 includes a first metal layer 1051 and a first metal diffusion inhibiting layer 1052 located on at least one side of the first metal layer 1051. The first metal diffusion inhibiting layer 1052 can inhibit diffusion of metal on the first metal layer 1051, that is, can inhibit diffusion of metal on the first metal layer 1051 to another film layer (for example, the first light absorption layer 103 and/or the second light absorption layer 107).

The first metal layer 1051 has two surfaces that are opposite to each other along a thickness direction thereof (for example, the x direction as shown in FIG. 1), and the first metal diffusion inhibiting layer 1052 may be disposed on at least one of the two opposite surfaces of the first metal layer 1051 along the thickness direction. For example, as shown in FIG. 1, the first metal diffusion inhibiting layer 1052 is disposed on the two opposite surfaces of the first metal layer 1051 along the thickness direction thereof.

Optionally, in some embodiments, the first metal diffusion inhibiting layer 1052 is disposed on one of the two surfaces of the first metal layer 1051 that are opposite to each other along the thickness direction.

The first metal diffusion inhibiting layer 1052 is disposed on at least one side of the first metal layer 1051, to form the composite layer 105 disposed between a second carrier transport layer 104 and a third carrier transport layer 106. In this way, on the at least one side of the first metal layer 1051, the first metal diffusion inhibiting layer 1052 separates the first metal layer 1051 from another film layer, and the first metal diffusion inhibiting layer 1052 prevents metal on the first metal layer 1051 from diffusing to the another film layer, to reduce a risk that a function of the another film layer is degraded or damaged due to doping of a metal material. Permeability of the composite layer 105 formed by the first metal layer 1051 and the first metal diffusion inhibiting layer 1052 on the at least one side of the first metal layer 1051 is improved, and a structural design of the composite layer 105 is conducive to improving parallel resistance of the solar cell 10 and is conducive to improving a filling factor of the solar cell 10.

Efficiency of the solar cell 10 may refer to photoelectric conversion efficiency of the solar cell 10, which is a ratio of a maximum output power of the cell when the cell is illuminated by sunlight to a power of incident light illuminating the cell.

The filling factor of the solar cell 10 may be used to measure the photoelectric conversion efficiency of the solar cell 10. Generally, the larger the filling factor, the greater the photoelectric conversion efficiency. The filling factor is related to a current density. The current density may refer to a current per unit area. A larger current area is more conducive to improving the filling factor.

The solar cell 10 provided in the embodiments of the present application includes: a first light absorption layer 103, a composite layer 105, and a second light absorption layer 107 that are sequentially arranged along a first direction, where the first direction is an incident direction of sunlight. Further, the composite layer includes a first metal layer 1051 and a first metal diffusion inhibiting layer 1052 located on at least one side of the first metal layer 1051. The first metal diffusion inhibiting layer 1052 is disposed on at least one side of the first metal layer 1051. In this way, on the at least one side of the first metal layer 1051, the first metal diffusion inhibiting layer 1052 separates the first metal layer 1051 from another film layer, and the first metal diffusion inhibiting layer 1052 prevents metal on the first metal layer 1051 from diffusing to the another film layer, to reduce a risk that a function of the another film layer is degraded or damaged due to doping of a metal material. Permeability of the composite layer 105 formed by the first metal layer 1051 and the first metal diffusion inhibiting layer 1052 on the at least one side of the first metal layer 1051 is improved, and a structural design of the composite layer 105 is conducive to improving parallel resistance of the solar cell 10 and is conducive to improving a filling factor of the solar cell 10. Therefore, the technical solutions provided in the present application are conducive to improving efficiency of the solar cell 10.

In some embodiments, as shown in FIG. 2, the solar cell may further include a first electrode layer 101, a first carrier transport layer 102, a second carrier transport layer 104, a third carrier transport layer 106, a fourth carrier transport layer 108, and a second electrode layer 109.

Specifically, the first electrode layer 101, the first carrier transport layer 102, a first light absorption layer 103, the second carrier transport layer 104, a composite layer 105, the third carrier transport layer 106, a second light absorption layer 107, the fourth carrier transport layer 108, and the second electrode layer 109 are sequentially arranged along an x direction.

The first electrode layer 101 and the second electrode layer 109 are conductive film layers. Connecting the first electrode layer 101 and the second electrode layer 109 can generate a photo-current, to supply power to an optoelectronic apparatus.

Optionally, in some embodiments, the first carrier transport layer 102 is a hole transport layer, the second carrier transport layer 104 is an electron transport layer, the third carrier transport layer 106 is a hole transport layer, the fourth carrier transport layer 108 is an electron transport layer, and the first metal diffusion inhibiting layer 1052 is disposed between the third carrier transport layer 106 and the metal layer.

Optionally, in some embodiments, the first carrier transport layer 102 is an electron transport layer, the second carrier transport layer 104 is a hole transport layer, the third carrier transport layer 106 is a hole transport layer, the fourth carrier transport layer 108 is an electron transport layer, and the first metal diffusion inhibiting layer 1052 is disposed on two sides of the first metal layer 1051. In other words, the first metal layer 1051 and the second carrier transport layer 104 are separated by the first metal diffusion inhibiting layer 1052, and the first metal layer 1051 and the third carrier transport layer 106 are separated by the first metal diffusion inhibiting layer 1052.

Optionally, in some embodiments, the first carrier transport layer 102 is a hole transport layer, the second carrier transport layer 104 is an electron transport layer, the third carrier transport layer 106 is an electron transport layer, and the fourth carrier transport layer 108 is a hole transport layer. The first metal diffusion inhibiting layer 1052 may be disposed on one side of the first metal layer 1051, or the first metal diffusion inhibiting layer 1052 may be disposed on two sides of the first metal layer 1051.

The hole transport layer is used to transport holes, and optionally, a material of the hole transport layer includes a P-type semiconductor. Optionally, the material of the hole transport layer includes at least one of the following materials and derivatives thereof: [4-(3,6-dimethoxy-9H-carbazole-9-yl)butyl phosphoric acid, [2-(3,6-dimethoxy-9H-carbazole-9-yl)ethyl]phosphoric acid, [4-(3,6-dibromo-9H-carbazole-9-yl)butyl]phosphoric acid, poly[bis(4-phenyl)(2,4,6-trimethylphenyl)amine], poly-3-hexylthiophene, triptycene-cored triphenylamine, 3,4-ethylenedioxythiophene-methoxytriphenylamine, N-(4-aniline)carbazole-spirobisfluorene, poly(3,4-ethylenedioxythiophene)-polystyrene sulfonic acid, polythiophene, nickel oxide, molybdenum oxide, cuprous iodide, and cuprous oxide.

The electron transport layer is used to transport electrons, and optionally, a material of the electron transport layer includes an N-type semiconductor. Optionally, the material of the electron transport layer includes at least one of the following materials and derivatives thereof: bathocuproine, [6,6]-phenyl-C61-methyl isobutyrate, [6,6]-phenyl-C71-methyl butyrate, C60, C70, SnOₓ, and zinc oxide. A value of x ranges from 1.5 to 2. For example, if x is 2, the material of the electron transport layer may be SnO₂.

In the foregoing technical solutions, the first metal diffusion inhibiting layer 1052 is disposed on one side of the first metal layer 1051 close to the hole transport layer. The first metal diffusion inhibiting layer 1052 separates the first metal layer 1051 from the hole transport layer, to reduce a risk of damage to the hole transport layer.

In some embodiments, as shown in FIG. 1 and FIG. 2, a thickness d1 of the first metal diffusion inhibiting layer 1052 satisfies: 0.1 nm≤d1≤100 nm. Optionally, d1 satisfies: 5 nm≤d1≤10 nm.

Specifically, the thickness d1 of the first metal diffusion inhibiting layer 1052 may be 0.1 nm, 1 nm, 10 nm, 20 nm, 30 nm, 40 nm, 50 nm, 60 nm, 70 nm, 80 nm, 90 nm, and 100 nm, or a value between any two of the foregoing values.

Setting the thickness d1 of the first metal diffusion inhibiting layer 1052 within the foregoing range is conducive to improving the efficiency of the solar cell 10.

In some embodiments, as shown in FIG. 1 and FIG. 2, a thickness d2 of the first metal layer 1051 satisfies: 0.1 nm≤d2≤10 nm. Optionally, d2 satisfies: 0.8 nm≤d2≤1.2 nm.

Specifically, the thickness d2 of the first metal layer 1051 may be 0.1 nm, 0.8 nm, 1 nm, 1.2 nm, 3 nm, 5 nm, 7 nm, and 10 nm, or a value between any two of the foregoing values.

Setting the thickness d2 of the first metal layer 1051 within the foregoing range is conducive to improving the efficiency of the solar cell 10.

In some embodiments, as shown in FIG. 1 and FIG. 2, a thickness d of the composite layer 105 satisfies: 1 nm≤d≤210 nm. Optionally, d satisfies: 10.8 nm≤d≤21.2 nm.

Specifically, the thickness d of the composite layer 105 may be 1 nm, 5 nm, 10 nm, 20 nm, 30 nm, 50 nm, 70 nm, 100 nm, 150 nm, 200 nm, and 210 nm, or a value between any two of the foregoing values.

Setting the thickness d of the composite layer 105 within the foregoing range is conducive to improving the efficiency of the solar cell 10.

In the technical solutions in the embodiments of the present application, a thickness of each film layer can be measured by using a step gauge. For a specific measurement method, refer to a known step gauge measurement method.

In some embodiments, a material of the first metal diffusion inhibiting layer 1052 includes at least one of a transparent conductive oxide and an elemental carbon material.

Optionally, the transparent conductive oxide includes at least one of indium tin oxide, fluorine-doped tin oxide, indium-doped tungsten oxide, indium-doped zinc oxide, and aluminum-doped zinc oxide.

Optionally, the elemental carbon material includes at least one of graphite, graphene, and a carbon nanotube.

The foregoing substance is used as the material of the first metal diffusion inhibiting layer 1052, to cover at least one side of the first metal layer 1051, which can reduce a risk that the material of the first metal layer 1051 diffuses to the carrier transport layer.

In some embodiments, a material of the first electrode layer 101 includes: a conductive oxide.

Optionally, the conductive oxide includes at least one of indium tin oxide, lanthanide-doped indium oxide, boron-doped zinc oxide, fluorine-doped tin oxide, indium-doped tungsten oxide, indium-doped zinc oxide, aluminum-doped zinc oxide, and gallium zinc oxide.

In the foregoing technical solutions, the material of the first electrode layer 101 includes the foregoing conductive oxide, which is conducive to absorbing sunlight by the solar cell 10.

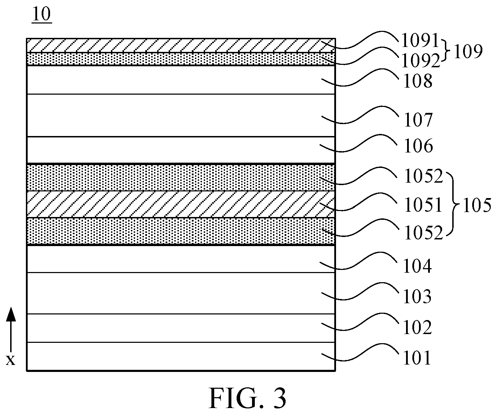

In some embodiments, as shown in FIG. 3, the second electrode layer 109 includes a second metal layer 1091 and a second metal diffusion inhibiting layer 1092, and the second metal diffusion inhibiting layer 1092 is disposed between the second metal layer 1091 and the fourth carrier transport layer 108. The second metal diffusion inhibiting layer 1092 can inhibit diffusion of metal on the second metal layer 1091, that is, can inhibit diffusion of metal on the second metal layer 1091 to the fourth carrier transport layer 108.

In the foregoing technical solutions, the second metal diffusion inhibiting layer 1092 of the second electrode layer 109 is disposed between the second metal layer 1091 of the second electrode layer 109 and the fourth carrier transport layer 108, which can block a metal material in the second metal layer 1091 from diffusing to the fourth carrier transport layer 108, thereby reducing a risk of damage to the fourth carrier transport layer 108.

In some embodiments, a material of the second metal layer 1091 includes at least one of gold, silver, copper, aluminum, nickel, chromium, bismuth, platinum, magnesium, molybdenum, tungsten, and alloys thereof. The second metal diffusion inhibiting layer 1092 includes at least one of a transparent conductive oxide and an elemental carbon material.

Optionally, the transparent conductive oxide includes at least one of indium tin oxide, fluorine-doped tin oxide, indium-doped tungsten oxide, indium-doped zinc oxide, and aluminum-doped zinc oxide.

Optionally, the elemental carbon material includes at least one of graphite, graphene, and a carbon nanotube.

The foregoing substance is used as the material of the second metal diffusion inhibiting layer 1092, and is disposed between the second metal layer 1091 and the fourth carrier transport layer 108, which can reduce a risk that the material of the second metal layer 1091 diffuses to the fourth carrier transport layer 108.

Optionally, in some embodiments, a material of the first light absorption layer 103 is perovskite, and a material of the second light absorption layer 107 is perovskite.

The perovskite is a light absorption material. When being illuminated by sunlight, the perovskite can generate electron-hole pairs. The perovskite material has advantages such as high conversion efficiency, low costs, and environmental protection, and can be made into a very thin film and applied to the solar cell 10, which can effectively improve efficiency of the solar cell 10.

In some embodiments, a band gap of the material of the first light absorption layer 103 is greater than a band gap of the material of the second light absorption layer 107.

The band gap refers to an energy difference between a lowest point of a conduction band and a highest point of a valence band in a semiconductor material.

Optionally, the band gap of the material of the first light absorption layer 103 ranges from 1.6 eV to 2.3 eV, and the band gap of the material of the second light absorption layer 107 ranges from 1.0 eV to 1.4 eV. For example, a perovskite material of the first light absorption layer 103 is bromine-iodine mixed perovskite, and a perovskite material of the second light absorption layer 107 is tin-lead mixed perovskite.

Optionally, in some embodiments, the material of the second light absorption layer 107 is silicon, copper indium gallium selenide, copper indium selenide, cadmium telluride, or gallium arsenide.

Sunlight first illuminates the first light absorption layer 103, and a band gap of the material of the first light absorption layer 103 is greater than a band gap of the material of the second light absorption layer 107. This is conducive to improving efficiency of the solar cell 10.

In some embodiments, a chemical formula of the perovskite in the first light absorption layer 103 and the second light absorption layer 107 is ABX₃, where A includes at least one of CH3(NH₂)₂⁺, CH(NH₂)₂⁺, CH₃NH₂⁺, Li⁺, Na⁺, K⁺, Rb⁺, and Cs⁺; B includes at least one of Pb⁺, Be²⁺, Mg²⁺, Ca²⁺, Sr²⁺, Ba²⁺, Zn²⁺, Ge²⁺, Fe²⁺, Co²⁺, and Ni²⁺; and X includes at least one of Cl , Br , I⁻, SCN , CNO , OCN , OSCN , SH , OH , CP , CN , SeCN , N₃⁻, and NO₂⁻. In this way, specific types of the perovskite are flexibly selected according to an actual requirement.

Optionally, in some embodiments, the solar cell 10 further includes a barrier layer, such as a hole barrier layer or an electron barrier layer. Specifically, an electron barrier layer is disposed between a light absorption layer and a hole transport layer, and a hole barrier layer is disposed between a light absorption layer and an electron transport layer.

The electron barrier layer can transport holes, and the hole barrier layer can transport electrons.

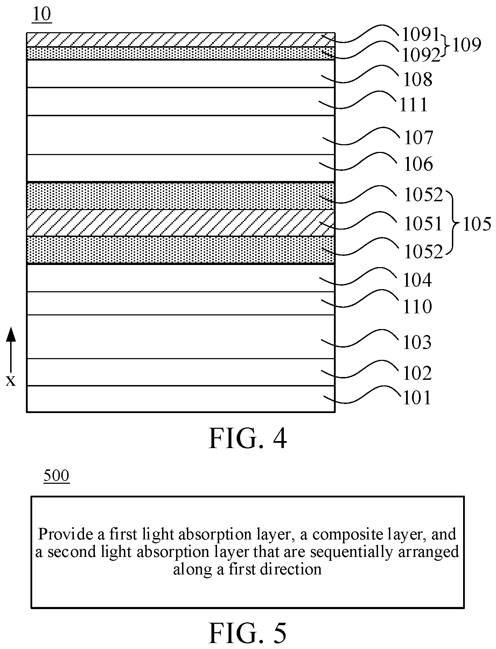

Optionally, as shown in FIG. 4, the solar cell 10 further includes a first hole barrier layer 110. When the second carrier transport layer 104 is the electron transport layer, the first hole barrier layer 110 is located between the first light absorption layer 103 and the second carrier transport layer 104.

Optionally, still referring to FIG. 4, the solar cell 10 further includes a second hole barrier layer 111. When the fourth carrier transport layer 108 is the electron transport layer, the second hole barrier layer 111 is located between the second light absorption layer 107 and the fourth carrier transport layer 108.

In the foregoing technical solutions, disposing a hole barrier layer between a light absorption layer and an electron transport layer is conducive to improving electron transport between the electron transport layer and the light absorption layer, thereby improving efficiency of the solar cell 10.

Optionally, in some embodiments, a material of the first hole barrier layer 110 and a material of the second hole barrier layer 111 include at least one of fullerene and derivatives thereof and SnOₓ, where a value of x ranges from 1.5 to 2. For example, x may be 2, and the material of the first hole barrier layer 110 and the material of the second hole barrier layer 111 may include SnO₂.

The foregoing material that is used as the material of the first hole barrier layer 110 and the material of the second hole barrier layer 111 can improve the efficiency of the solar cell 10.

### [Preparation method for a solar cell]

The solar cell provided in the embodiments of the present application is described above. The preparation method for the solar cell provided in the embodiments of the present application is described below. Parts similar to the solar cell described above are not repeated.

FIG. 5 shows a preparation method for a solar cell according to an embodiment of the present application. As shown in FIG. 5, the preparation method 500 includes: providing a first light absorption layer, a composite layer, and a second light absorption layer that are sequentially arranged along a first direction.

The first direction is an incident direction of sunlight. The composite layer includes a first metal layer and a first metal diffusion inhibiting layer located on at least one side of the first metal layer.

The solar cell prepared in the foregoing method has relatively high cell efficiency.

Optionally, in some embodiments, the preparation method further includes: providing a first electrode layer, a first carrier transport layer, the first light absorption layer, a second carrier transport layer, the composite layer, a third carrier transport layer, the second light absorption layer, a fourth carrier transport layer, and a second electrode layer that are sequentially arranged along the first direction.

Optionally, in some embodiments, the preparation method includes: providing the first electrode layer; preparing the first carrier transport layer on the first electrode layer, where the first carrier transport layer is a hole transport layer; preparing the first light absorption layer on the first carrier transport layer; preparing the second carrier transport layer on the first light absorption layer, where the second carrier transport layer is an electron transport layer; preparing the first metal layer on the electron transport layer, and preparing the first metal diffusion inhibiting layer on the metal layer, to obtain the composite layer; preparing the third carrier transport layer on the composite layer, where the third carrier transport layer is a hole transport layer; preparing the second light absorption layer on the third carrier transport layer; preparing the fourth carrier transport layer on the second light absorption layer, where the fourth carrier transport layer is an electron transport layer; and preparing the second electrode layer on the fourth carrier transport layer.

Optionally, in some embodiments, the second electrode layer includes a second metal layer and a second metal diffusion inhibiting layer, and the preparing the second electrode layer on the fourth carrier transport layer includes: preparing the second metal diffusion inhibiting layer on the fourth carrier transport layer, and preparing the second metal layer on the second metal diffusion inhibiting layer, to obtain the second electrode layer.

In some embodiments, a thickness d1 of the first metal diffusion inhibiting layer satisfies: 0.1 nm≤d1≤100 nm. Optionally, d1 satisfies: 5 nm≤d1≤10 nm.

In some embodiments, a thickness d2 of the first metal layer satisfies: 0.1 nm≤d2≤10 nm. Optionally, d2 satisfies: 0.8 nm≤d2≤1.2 nm.

In some embodiments, a thickness d of the composite layer satisfies: 1 nm≤d≤210 nm. Optionally, d satisfies: 10.8 nm≤d≤21.2 nm.

In some embodiments, a material of the first metal layer includes at least one of gold, silver, copper, aluminum, nickel, chromium, bismuth, platinum, magnesium, molybdenum, tungsten, and alloys thereof. Optionally, the material of the first metal layer includes at least one of gold and silver.

In some embodiments, a material of the first metal diffusion inhibiting layer includes at least one of a transparent conductive oxide and an elemental carbon material. Optionally, the transparent conductive oxide includes at least one of indium tin oxide, fluorine-doped tin oxide, indium-doped tungsten oxide, indium-doped zinc oxide, and aluminum-doped zinc oxide. Optionally, the elemental carbon material includes at least one of graphite, graphene, and a carbon nanotube.

Optionally, in some embodiments, a material of the first light absorption layer is perovskite, and a material of the second light absorption layer is perovskite.

In some embodiments, a band gap of the material of the first light absorption layer is greater than a band gap of the material of the second light absorption layer.

Embodiments of the present application further provide a photovoltaic module. Generally, the photovoltaic module includes the solar cell, and/or a solar cell prepared according to the foregoing preparation method, a welding strip connecting a plurality of solar cells, a junction box for current transmission, and a cell encapsulation component.

In some implementations, the battery encapsulation component includes photovoltaic glass. The photovoltaic glass covers the solar cell and serves to protect the solar cell. In addition, the photovoltaic glass has excellent light transmittance and high hardness, and can adapt to a large temperature difference between day and night and a harsh weather condition.

In some implementations, the cell encapsulation component includes an EVA film disposed between the photovoltaic glass and the solar cell for bonding the photovoltaic glass and the solar cell.

In some implementations, the cell encapsulation component includes a photovoltaic backsheet, and the photovoltaic backsheet also serves to protect the solar cell.

Optionally, the photovoltaic backsheet can be made of a polyvinyl fluoride composite film or a thermoplastic elastic material. A material of the photovoltaic backsheet has properties such as insulation, water resistance, and aging resistance.

In some implementations, the battery encapsulation component includes a solar aluminum frame made of an aluminum alloy, which has properties such as high strength and good corrosion resistance, and can support and protect the solar cell.

Embodiments of the present application further provide a photovoltaic apparatus, including the photovoltaic module provided in the foregoing embodiments.

In some embodiments, the photovoltaic apparatus may be further a lighting device, an energy storage device, and the like, and the embodiments of the present application include, but are not limited thereto. For example, the photovoltaic apparatus may be a solar water heater, a solar streetlight, and a solar photovoltaic generator.

### [Embodiment]

Examples of the present application are described below. The examples described below are illustrative, are merely used to explain the present application, and should not be construed as a limitation to the present application. The embodiments in which specific technologies or conditions are not indicated shall be carried out in accordance with the technologies or conditions described in the literature in the art or in accordance with the product specification. The reagents or instruments for which no manufacturer is noted are all common products commercially available from the market.

### 1. Preparation of a solar cell

### [Embodiment 1]

Embodiment 1 corresponds to a structure of the solar cell shown in FIG. 1.

First electrode layer: The first electrode layer is disposed on a glass substrate. A material of the first electrode layer is indium tin oxide (ITO). The glass substrate with the first electrode layer is cleaned sequentially with acetone-alcohol-deionized water and then dried for later use.

First carrier transport layer (hole transport layer): [4-(3,6-dimethoxy-9H-carbazole-9-yl)butyl]phosphoric acid (MeO-4PACz) is added to an ethanol solvent and stirred. The ethanol solution of MeO-4PACz is spin-coated onto the first electrode layer (a spin-coating speed is 4000 rpm and spin-coating duration is 30s), and is then transferred to a hot plate and annealed at 100°C for 10 minutes, to form the first carrier transport layer.

First light absorption layer: CH(NH₂)₂I of 123 mg, CH(NH₂)₂Br of 59 mg, CsI of 46 mg, CsBr of 25 mg, PbI₂ of 428 mg, and PbBr₂ of 209 mg are added to a mixed solvent of DMF and DMSO of 1 mL (a volume ratio of DMF to DMSO is 3: 1). The solvent is stirred at 600 rpm for 8 hours in a magnetic stirrer and then filtered, to obtain a perovskite precursor solution. The foregoing perovskite precursor solution of 100 µL is spin-coated onto the first carrier transport layer (first spin-coating is performed at a spin-coating speed of 2000 rpm and an acceleration of 200 rpm/s for 10s, and then spin-coating is performed at a spin-coating speed of 4000 rpm and an acceleration of 1000 rpm/s for 25s). Then, chlorobenzene of 200 µL is added dropwise onto the spin-coated perovskite precursor solution. The perovskite precursor solution is then spin-coated again (a spin-coating speed is 4000 rpm and spin-coating duration is 15s). The solution is then transferred to a hot plate and annealed at 100°C for 15 minutes, to form the first light absorption layer.

Second carrier transport layer (electron transport layer): A layer of SnO₂ with a thickness of 20 nm is prepared on the first light absorption layer by using an atomic layer deposition (ALD) device, to form the second carrier transport layer.

Composite layer: A layer of ITO with a thickness of 5 nm is prepared on the second carrier transport layer by using the ALD device, to form a first metal diffusion inhibiting layer with a thickness d1 of 5 nm. Then, a layer of elemental gold (Au) with a thickness of 1 nm is deposited on the first metal diffusion inhibiting layer by using an evaporation device, to form a first metal layer with a thickness d2 of 1 nm. Finally, a layer of ITO with a thickness of 5 nm is prepared on the first metal layer by using the ALD device, to form another first metal diffusion inhibiting layer with a thickness d1 of 5 nm, to obtain the composite layer.

Third carrier transport layer (hole transport layer): Poly(3,4-ethylenedioxythiophene)-polystyrene sulfonic acid (PEDOT:PSS) is spin-coated onto the foregoing composite layer (a spin-coating speed is 4000 rpm and spin-coating duration is 30s), and is then transferred to a hot plate and annealed at 150°C for 10 minutes, to form the third carrier transport layer.

Second light absorption layer: CH(NH₂)₂I of 216 mg, CH₃NH₂I of 85 mg, PbI₂ of 414 mg, SnI₂ of 335 mg, and MeO-4PACz of 0.5 mg are added to a mixed solvent of DMF and DMSO of 1 mL (a volume ratio of DMF to DMSO is 3:1). The solvent is stirred at 600 rpm for 2 hours in a magnetic stirrer and then filtered, to obtain a perovskite precursor solution. The foregoing perovskite precursor solution of 100 µL is spin-coated onto the third carrier transport layer (first spin-coating is performed at a spin-coating speed of 1000 rpm and an acceleration of 200 rpm/s for 10s, and then spin-coating is performed at a spin-coating speed of 3000 rpm and an acceleration of 1000 rpm/s for 20s). Then, ethyl acetate of 350 µL is added dropwise onto the spin-coated perovskite precursor solution. The perovskite precursor solution is then spin-coated again (a spin-coating speed is 4000 rpm and spin-coating duration is 20s). The solution is then transferred to a hot plate and annealed at 100°C for 10 minutes, to form the second light absorption layer.

Fourth carrier transport layer (electron transport layer): A layer of 10% bathocuproine (BCP) is deposited on the second light absorption layer, to form the fourth carrier transport layer.

Second electrode layer: A layer of metallic copper (Cu) with a thickness of 100 nm is deposited on the foregoing fourth carrier transport layer, to form the second electrode layer. The solar cell in Embodiment 1 is finally obtained.

### [Embodiment 2 to Embodiment 5 and Embodiment 10]

Preparation in Embodiment 2 to Embodiment 5 and Embodiment 10 is similar to preparation in Embodiment 1, and a difference lies in that the thickness d1 of the first metal diffusion inhibiting layer in Embodiment 2 to Embodiment 5 and Embodiment 10 is 0.1 nm, 1.0 nm, 10 nm, 100 nm, and 120 nm respectively. For details, refer to Table 1.

### [Embodiment 6 to Embodiment 9 and Embodiment 11]

Preparation in Embodiment 6 to Embodiment 9 and Embodiment 11 is similar to preparation in Embodiment 1, and a difference lies in that the thickness d2 of the second metal layer in Embodiment 6 to Embodiment 9 and Embodiment 11 is 0.1 nm, 0.8 nm, 1.2 nm, 10 nm, and 12 nm respectively. For details, refer to Table 1.

### [Embodiment 12]

Preparation in Embodiment 12 is similar to preparation in Embodiment 1, and a difference lies in preparation of the composite layer in Embodiment 12: A layer of elemental Au with a thickness of 1 nm is deposited on the second carrier transport layer by using an evaporation device, to form a first metal layer with a thickness d2 of 1 nm. Then, a layer of ITO with a thickness of 5 nm is prepared on the first metal layer by using the ALD device, to form a first metal diffusion inhibiting layer with a thickness d1 of 5 nm, to obtain the composite layer.

### [Embodiment 13]

Preparation in Embodiment 13 is similar to preparation in Embodiment 1, and a difference lies in preparation of the first carrier transport layer and the second carrier transport layer in Embodiment 13: The first carrier transport layer in Embodiment 13 is an electron transport layer. A layer of SnO₂ with a thickness of 20 nm is prepared on the first electrode layer by using the ALD device, to form the first carrier transport layer. The second carrier transport layer is a hole transport layer. MeO-4PACz is added to an ethanol solvent and stirred. The ethanol solution of MeO-4PACz is spin-coated onto the first light absorption layer (a spin-coating speed is 4000 rpm and spin-coating duration is 30s), and is then transferred to a hot plate and annealed at 100°C for 10 minutes, to form the second carrier transport layer.

### [Embodiment 14]

Preparation in Embodiment 14 is similar to preparation in Embodiment 1, and a difference lies in preparation of the second electrode layer in Embodiment 14: A layer of ITO with a thickness of 5 nm is prepared on the fourth carrier transport layer by using the ALD device, to form the second metal diffusion inhibiting layer, and then a layer of metallic copper (Cu) with a thickness of 100 nm is deposited on the second metal diffusion inhibiting layer, to form the second metal layer, so as to obtain the second electrode layer.

### [Embodiment 15]

Preparation in Embodiment 15 is similar to preparation in Embodiment 1, and a difference lies in that in Embodiment 15, the solar cell further includes a first hole barrier layer and a second hole barrier layer. Specifically, the first hole barrier layer is disposed between the first light absorption layer and the second carrier transport layer. A layer of C60 with a thickness of 25 nm is deposited on the first light absorption layer, to form the first hole barrier layer. Then, the second carrier transport layer is prepared on the first hole barrier layer (for a preparation process of the second carrier transport layer, refer to Embodiment 1). The second hole barrier layer is disposed between the second light absorption layer and the fourth carrier transport layer. A layer of C60 with a thickness of 25 nm is deposited on the second light absorption layer, to form the second hole barrier layer. Then, the second electrode layer is prepared on the second hole barrier layer (for a preparation process of the second electrode layer, refer to Embodiment 1).

### [Embodiment 16]

Preparation in Embodiment 16 is similar to preparation in Embodiment 1, and a difference lies in that in Embodiment 16, a material of the first metal diffusion inhibiting layer is fluorine-doped tin oxide (FTO). For details, refer to Table 1.

### [Embodiment 17]

Preparation in Embodiment 17 is similar to preparation in Embodiment 1, and a difference lies in that in Embodiment 17, a material of the first metal layer is elemental silver (Ag). For details, refer to Table 1.

### [Embodiment 18]

Preparation in Embodiment 18 is similar to preparation in Embodiment 1, and a difference lies that in Embodiment 18, a material of the second light absorption layer is monocrystalline silicon. Preparation of the second light absorption layer: The monocrystalline silicon is cleaned and texturized by using a strong alkali, to obtain a double-textured surface. Subsequently, a layer of intrinsic i-type amorphous silicon with a thickness of 5 nm and a layer of doped P-type amorphous silicon with a thickness of 100 nm are separately prepared on one side of the double-textured monocrystalline silicon wafer by using a plasma-enhanced chemical vapor deposition (PECVD) device. Then, a layer of intrinsic i-type amorphous silicon with a thickness of 5 nm and a layer of doped N-type amorphous silicon with a thickness of 100 nm are prepared on the other side of the double-textured monocrystalline silicon wafer by using the same PECVD device. A layer of ITO with a thickness of 100 nm is then separately prepared on two sides of the prepared amorphous silicon sample by using a physical vapor deposition (PVD) device, to obtain the second light absorption layer.

### [Comparative embodiment 1 and Comparative embodiment 2]

Preparation in Comparative embodiment 1 and Comparative embodiment 2 is similar to preparation in Embodiment 1, and a difference lies in that in Comparative embodiment 1, the composite layer includes only a layer of elemental gold with a thickness of 1 nm, and in Comparative embodiment 2, the composite layer includes only a layer of ITO with a thickness of 100 nm.

Next, a test process of solar cell performance is described.

### 2. Solar cell performance test

The cell performance is tested under standard simulated sunlight (AM 1.5 G, 100 mW/cm2), to obtain an I-V curve. According to the I-V curve and data fed back by a testing device, a short-circuit current Jsc (in a unit of mA/cm²), an open-circuit voltage Voc (in a unit of V), a maximum optical output current Jmpp (in a unit of mA), and a maximum optical output voltage Vmpp (in a unit of V) can be obtained. A filling factor FF, in a unit of %, of the cell is calculated by using the formula FF=Jsc×Voc/(Jmpp×Vmpp). The photoelectric conversion efficiency PCE, in a unit of %, of the cell is calculated by using the formula PCE=Jsc×Voc×FF/Pin; and Pin represents an input power of incident light, in a unit of mW.

Cell performance test is performed on Embodiment 1 to Embodiment 18 and Comparative embodiment 1 and Comparative embodiment 2 that are prepared according to the foregoing method. For test results, refer to Table 1. In Table 1, d1 represents the thickness of the first metal diffusion inhibiting layer, d2 represents the thickness of the first metal layer, and d represents the thickness of the composite layer.

**Table 1: Product parameters and performance test results of Embodiment 1 to Embodiment 18 and Comparative embodiment 1 and Comparative embodiment 2**

| Number | Composite layer | | | | | | Second electrode layer | | Second light absorption layer | Whether a barrier layer is disposed | Filling factor FF/% | Efficiency PCE/% |
|---|---|---|---|---|---|---|---|---|---|---|---|---|
| | First metal diffusion inhibiting layer | | | First metal layer | | d1/nm | Second metal diffusion inhibiting layer | Second metal layer | | | | |
| | Layer quantity | Material | d1/nm | Material | d2/nm | | | | | | | |
| Embodiment 1 | 2 | ITO | 5 | Au | 1 | 11 | / | Cu | Perovskite | No | 82.5 | 23.5 |
| Embodiment 2 | 2 | ITO | 0.1 | Au | 1 | 1.2 | / | Cu | Perovskite | No | 80.7 | 23.0 |
| Embodiment 3 | 2 | ITO | 1.0 | Au | 1 | 3 | / | Cu | Perovskite | No | 81.2 | 23.1 |
| Embodiment 4 | 2 | ITO | 10 | Au | 1 | 21 | / | Cu | Perovskite | No | 80.4 | 22.9 |
| Embodiment 5 | 2 | ITO | 100 | Au | 1 | 201 | / | Cu | Perovskite | No | 78.9 | 22.5 |
| Embodiment 6 | 2 | ITO | 5 | Au | 0.1 | 10.1 | / | Cu | Perovskite | No | 80.0 | 22.8 |
| Embodiment 7 | 2 | ITO | 5 | Au | 0.8 | 10.8 | / | Cu | Perovskite | No | 81.1 | 23.1 |
| Embodiment 8 | 2 | ITO | 5 | Au | 1.2 | 11.2 | / | Cu | Perovskite | No | 80.4 | 22.9 |
| Embodiment 9 | 2 | ITO | 5 | Au | 10 | 30 | / | Cu | Perovskite | No | 78.6 | 22.4 |
| Embodiment 10 | 2 | ITO | 120 | Au | 1 | 241 | / | Cu | Perovskite | No | 76.8 | 21.9 |
| Embodiment 11 | 2 | ITO | 5 | Au | 12 | 22 | / | Cu | Perovskite | No | 77.9 | 22.2 |
| Embodiment 12 | 1 | ITO | 5 | Au | 1 | 6 | / | Cu | Perovskite | No | 81.7 | 23.3 |
| Embodiment 13 | 2 | ITO | 5 | Au | 1 | 11 | / | Cu | Perovskite | No | 80.0 | 22.8 |
| Embodiment 14 | 2 | ITO | 5 | Au | 1 | 11 | ITO | Cu | Perovskite | No | 80.5 | 22.9 |
| Embodiment 15 | 2 | ITO | 5 | Au | 1 | 11 | / | Cu | Perovskite | | 83.5 | 23.8 |
| Embodiment 16 | 2 | FTO | 5 | Au | 1 | 11 | / | Cu | Perovskite | No | 80.7 | 23.0 |
| Embodiment 17 | 2 | ITO | 5 | Ag | 1 | 11 | / | Cu | Perovskite | No | 80.0 | 22.8 |
| Embodiment 18 | 2 | ITO | 5 | Au | 1 | 11 | / | Cu | Monocrystalline silicon | No | 82.1 | 23.4 |
| Comparative embodiment 1 | / | / | / | Au | 1 | 1 | / | Cu | Perovskite | No | 71.6 | 21.2 |
| Comparative embodiment 2 | 1 | ITO | 100 | / | / | 100 | / | Cu | Perovskite | No | 71.2 | 21.1 |

It can be learnt from comparison of results of Comparative embodiment 1 and Comparative embodiment 2 and Embodiment 1 to Embodiment 13 that, the composite layer disposed between the first light absorption layer and the second light absorption layer in the solar cell uses a composite structure of a metal layer and a protective layer disposed on at least one side of the metal layer, which improves efficiency of the solar cell.

It can be learnt from comparison of results of Embodiment 1 to Embodiment 5 and Embodiment 10 that, when the thickness of the first metal diffusion inhibiting layer is set within a proper range, effects of efficiency improvement of the solar cell are more significant. When other conditions are the same, the thickness of the first metal diffusion inhibiting layer is set within a range of 0.1 nm to 100 nm, so that the effects of the efficiency improvement of the solar cell are more significant.

It can be learnt from comparison of results of Embodiment 6 to Embodiment 9 and Embodiment 11 that, when the thickness of the first metal layer is set within a proper range, effects of efficiency improvement of the solar cell is more significant. When other conditions are the same, the thickness of the first metal layer is set within a range of 0.8 nm to 1.2 nm, so that the efficiency improvement of the solar cell is more significant.

It can be learnt from comparison of results of Embodiment 1 and Embodiment 15 that, disposing a hole barrier layer between a light absorption layer and an electron transport layer is conducive to improving efficiency of the solar cell.

It should be noted that the present application is not limited to the foregoing implementations. The foregoing implementations are merely examples, and implementations having substantially the same technical idea and the same effects within the scope of the technical solutions of the present application are all included in the technical scope of the present application. In addition, without departing from the scope of the subject matter of the present application, various modifications that can be conceived by a person skilled in the art are applied to the implementations, and other modes constructed by combining some of the constituent elements of the implementations are also included in the scope of the present application.

## Claims

1. A solar cell, comprising:
a first light absorption layer, a composite layer, and a second light absorption layer that are sequentially arranged along a first direction, wherein the first direction is an incident direction of sunlight; and
the composite layer comprises a first metal layer and a first metal diffusion inhibiting layer located on at least one side of the first metal layer.

2. The solar cell according to claim 1, wherein the solar cell further comprises a first electrode layer, a first carrier transport layer, a second carrier transport layer, a third carrier transport layer, a fourth carrier transport layer, and a second electrode layer, wherein the first electrode layer, the first carrier transport layer, the first light absorption layer, the second carrier transport layer, the composite layer, the third carrier transport layer, the second light absorption layer, the fourth carrier transport layer, and the second electrode layer are sequentially arranged along the first direction.

3. The solar cell according to claim 2, wherein the first carrier transport layer is a hole transport layer, the second carrier transport layer is an electron transport layer, the third carrier transport layer is a hole transport layer, the fourth carrier transport layer is an electron transport layer, and the first metal diffusion inhibiting layer is disposed between the third carrier transport layer and the first metal layer.

4. The solar cell according to any one of claims 1 to 3, wherein a thickness d1 of the first metal diffusion inhibiting layer satisfies: 0.1 nm≤d1≤100 nm.

5. The solar cell according to claim 4, wherein the thickness d1 of the first metal diffusion inhibiting layer satisfies: 5 nm≤d1≤10 nm.

6. The solar cell according to any one of claims 1 to 5, wherein a thickness d2 of the first metal layer satisfies: 0.1 nm≤d2≤10 nm.

7. The solar cell according to claim 6, wherein the thickness d2 of the first metal layer satisfies: 0.8 nm≤d2≤1.2 nm.

8. The solar cell according to any one of claims 1 to 7, wherein a thickness d of the composite layer satisfies: 1 nm≤d≤210 nm.

9. The solar cell according to claim 8, wherein the thickness d of the composite layer satisfies: 10.8 nm≤d≤21.2 nm.

10. The solar cell according to any one of claims 1 to 9, wherein a material of the first metal layer comprises at least one of gold, silver, copper, aluminum, nickel, chromium, bismuth, platinum, magnesium, molybdenum, tungsten, and alloys thereof.

11. The solar cell according to claim 10, wherein the material of the first metal layer comprises at least one of gold, silver, and alloys thereof.

12. The solar cell according to any one of claims 1 to 11, wherein a material of the first metal diffusion inhibiting layer comprises at least one of a transparent conductive oxide and an elemental carbon material.

13. The solar cell according to claim 12, wherein the transparent conductive oxide comprises at least one of indium tin oxide, fluorine-doped tin oxide, indium-doped tungsten oxide, indium-doped zinc oxide, and aluminum-doped zinc oxide; and
the elemental carbon material comprises at least one of graphite, graphene, and a carbon nanotube.

14. The solar cell according to claim 2, wherein a material of the first electrode layer comprises: a conductive oxide, wherein the conductive oxide comprises at least one of indium tin oxide, lanthanide-doped indium oxide, boron-doped zinc oxide, fluorine-doped tin oxide, indium-doped tungsten oxide, indium-doped zinc oxide, aluminum-doped zinc oxide, and gallium zinc oxide.

15. The solar cell according to claim 2, wherein the second electrode layer comprises a second metal layer and a second metal diffusion inhibiting layer, and the second metal diffusion inhibiting layer is disposed between the second metal layer and the fourth carrier transport layer.

16. The solar cell according to claim 15, wherein
a material of the second metal layer comprises at least one of gold, silver, copper, aluminum, nickel, chromium, bismuth, platinum, magnesium, molybdenum, tungsten, and alloys thereof; and
the second metal diffusion inhibiting layer comprises at least one of a transparent conductive oxide and an elemental carbon material.

17. The solar cell according to claim 16, wherein the transparent conductive oxide comprises at least one of indium tin oxide, fluorine-doped tin oxide, indium-doped tungsten oxide, indium-doped zinc oxide, and aluminum-doped zinc oxide; and
the elemental carbon material comprises at least one of graphite, graphene, and a carbon nanotube.

18. The solar cell according to claim 3, wherein a material of the hole transport layer comprises a P-type semiconductor, and a material of the electron transport layer comprises an N-type semiconductor.

19. The solar cell according to claim 18, wherein the material of the hole transport layer comprises at least one of the following materials and derivatives thereof: [4-(3,6-dimethoxy-9H-carbazole-9-yl)butyl]phosphoric acid, [2-(3,6-dimethoxy-9H-carbazole-9-yl)ethyl]phosphoric acid, [4-(3,6-dibromo-9H-carbazole-9-yl)butyl]phosphoric acid, poly[bis(4-phenyl)(2,4,6-trimethylphenyl)amine], poly-3-hexylthiophene, triptycene-cored triphenylamine, 3,4-ethylenedioxythiophene-methoxytriphenylamine, N-(4-aniline)carbazole-spirobisfluorene, poly(3,4-ethylenedioxythiophene)-polystyrene sulfonic acid, polythiophene, nickel oxide, molybdenum oxide, cuprous iodide, and cuprous oxide; and
the material of the electron transport layer comprises at least one of the following materials and derivatives thereof: bathocuproine, [6,6]-phenyl-C61-methyl isobutyrate, [6,6]-phenyl-C71-methyl butyrate, C60, C70, SnOₓ, and zinc oxide, wherein a value of x ranges from 1.5 to 2.

20. The solar cell according to any one of claims 1 to 19, wherein a material of the first light absorption layer is perovskite, and a material of the second light absorption layer is perovskite.

21. The solar cell according to claim 20, wherein a band gap of the material of the first light absorption layer is greater than a band gap of the material of the second light absorption layer.

22. The solar cell according to claim 21, wherein a chemical formula of the perovskite in the first light absorption layer and the second light absorption layer is ABX₃, wherein
A comprises at least one of CH3(NH₂)₂⁺, CH(NH₂)₂⁺, CH₃NH₂⁺, Li⁺, Na⁺, K⁺, Rb⁺, and Cs⁺; B comprises at least one of Pb⁺, Be²⁺, Mg²⁺, Ca²⁺, Sr²⁺, Ba²⁺, Zn²⁺, Ge²⁺, Fe²⁺, Co²⁺, and Ni²⁺; and X comprises at least one of Cl , Br⁻, I , SCN , CNO⁻, OCN , OSCN , SH , OH , CP , CN , SeCN , N₃⁻, and NO₂⁻.

23. The solar cell according to claim 3, wherein the solar cell further comprises a first hole barrier layer, and the first hole barrier layer is located between the first light absorption layer and the second carrier transport layer.

24. The solar cell according to claim 23, wherein a material of the first hole barrier layer comprises at least one of fullerene and derivatives thereof and SnOₓ, wherein a value of x ranges from 1.5 to 2.

25. The solar cell according to claim 3, wherein the solar cell further comprises a second hole barrier layer, and the second hole barrier layer is located between the second light absorption layer and the fourth carrier transport layer.

26. The solar cell according to claim 25, wherein a material of the second hole barrier layer comprises at least one of fullerene and derivatives thereof and SnOₓ, wherein a value of x ranges from 1.5 to 2.

27. A preparation method for a solar cell, comprising:
providing a first light absorption layer, a composite layer, and a second light absorption layer that are sequentially arranged along a first direction, wherein the first direction is an incident direction of sunlight; and
the composite layer comprises a first metal layer and a first metal diffusion inhibiting layer located on at least one side of the first metal layer.

28. The preparation method according to claim 27, wherein the preparation method further comprises:
providing a first electrode layer, a first carrier transport layer, the first light absorption layer, a second carrier transport layer, the composite layer, a third carrier transport layer, the second light absorption layer, a fourth carrier transport layer, and a second electrode layer that are sequentially arranged along the first direction.

29. The preparation method according to claim 28, wherein the providing a first electrode layer, a first carrier transport layer, the first light absorption layer, a second carrier transport layer, the composite layer, a third carrier transport layer, the second light absorption layer, a fourth carrier transport layer, and a second electrode layer that are sequentially arranged along the first direction comprises:
providing the first electrode layer;
preparing the first carrier transport layer on the first electrode layer, wherein the first carrier transport layer is a hole transport layer;
preparing the first light absorption layer on the first carrier transport layer;
preparing the second carrier transport layer on the first light absorption layer, wherein the second carrier transport layer is an electron transport layer;
preparing the first metal layer on the second carrier transport layer, and preparing the first metal diffusion inhibiting layer on the first metal layer, to obtain the composite layer;
preparing the third carrier transport layer on the composite layer, wherein the third carrier transport layer is a hole transport layer;
preparing the second light absorption layer on the third carrier transport layer;
preparing the fourth carrier transport layer on the second light absorption layer, wherein the fourth carrier transport layer is an electron transport layer; and
preparing the second electrode layer on the fourth carrier transport layer.

30. The preparation method according to claim 29, wherein the second electrode layer comprises a second metal layer and a second metal diffusion inhibiting layer, and the preparing the second electrode layer on the fourth carrier transport layer comprises:
preparing the second metal diffusion inhibiting layer on the fourth carrier transport layer, and preparing the second metal layer on the second metal diffusion inhibiting layer, to obtain the second electrode layer.

31. A photovoltaic module, comprising the solar cell according to any one of claims 1 to 26, and/or the solar cell prepared according to the preparation method according to any one of claims 27 to 30.

32. A photovoltaic apparatus, comprising the photovoltaic module according to claim 31.
